# EUROPEAN PATENT APPLICATION

(11) **EP 4 471 831 A1**
(43) Date of publication of application: **04.12.2024**
(21) Application number: 23743390.9
(22) Date of filing: 05.01.2023
(51) Int. Cl.: H01L 21/02

(54) **INSULATION FILM MANUFACTURING METHOD OF SEMICONDUCTOR PROCESS**

(30) Priority: 24.01.2022 KR 20220009707
(71) Applicant: HPSP Co., Ltd., Hwaseong-si, Gyeonggi-do 18449 (KR)
(72) Inventor: CHO, Sung Kil, Yongin-si, Gyeonggi-do 16995 (KR)
(74) Representative: von Bülow & Tamada
(86) International application number: PCT/KR2023/000212
(87) International publication number: WO 2023/140541

(57) **Abstract**

The present invention provides an insulating film manufacturing method of a semiconductor process, the method comprises the steps of: placing a wafer in a processing chamber; by supplying a source gas to the processing chamber at a first pressure higher than an atmospheric pressure, forming an insulating film on the wafer as at least one of an oxidation process and a nitridation process proceeds; by supplying a purge gas to the processing chamber, purging the source gas; and, by supplying atmospheric gas to the processing chamber at a second pressure higher than atmospheric pressure, strengthening the insulation film as the heat treatment process proceeds.

## Description

### [Technical Field]

The present invention relates to an insulation film manufacturing method used in a semiconductor process.

### [Background Art]

In general, a semiconductor manufacturing process may be largely classified into a pre-process and a post-process. The pre-process may include oxidation, deposition, exposure, etching, ion implantation, wiring, and the like.

An insulation film may be formed on a wafer by the oxidation process or the deposition process. The insulation film may prevent a leakage current from occurring even after a circuit pattern is formed. The insulation film may also serve as a protective film in the subsequent etching process or the like. Therefore, a qualitative property of the insulation film, such as density, is required to be secured to a certain level or above.

However, the insulation film formed by the conventional deposition process or oxidation process may not have a sufficient level of a qualitative property. In order to improve this problem, a process that takes a long time is required or a process temperature is required to be excessively high. The long-time process or the like may cause a lower efficiency of the semiconductor manufacturing process.

### [Disclosure]

### [Technical Problem]

An object of the present invention is to provide an insulation film manufacturing method of a semiconductor process, which may produce an insulation film having an excellent qualitative property without requiring an excessive processing time or temperature.

### [Technical Solution]

According to an embodiment of the present invention, provided is an insulation film manufacturing method of a semiconductor process, the method including: disposing a wafer in a processing area; forming an insulation film on the wafer by supplying source gas to the processing area at a first pressure higher than an atmospheric pressure to thus perform at least one of an oxidation process and a nitridation process; purging the source gas by supplying purge gas to the processing area; and strengthening the insulation film by supplying atmospheric gas to the processing area at a second pressure higher than the atmospheric pressure to thus perform a heat treatment process.

The first pressure may have a determined value within a range of 5 ATM to 20 ATM.

The forming of the insulation film on the wafer by supplying the source gas to the processing area at the first pressure higher than the atmospheric pressure to thus perform the at least one of the oxidation process and the nitridation process may include maintaining the source gas at a first temperature, and the first temperature may have a determined value within a range of 400°C to 600°C.

The source gas may include at least one of oxygen gas, water vapor, and ammonia gas.

The purging of the source gas by supplying the purge gas to the processing area may be performed while maintaining the processing area at the first pressure and a first temperature.

The purge gas may include one of nitrogen gas, argon gas, and helium gas.

The second pressure may have a determined value within a range of 5 ATM to 20 ATM.

The atmospheric gas may include at least one of hydrogen gas, deuterium gas, and nitrogen gas.

The method may further include maintaining an accommodation area accommodating the processing area at a pressure higher than one of the first pressure and the second pressure while the processing area is maintained at one of the first pressure and the second pressure.

### [Advantageous Effects]

According to the insulation film manufacturing method of a semiconductor process according to the present invention configured as above, it is possible to form the insulation film on the wafer by performing the oxidation or nitridation process using the source gas at the first pressure higher than the atmospheric pressure, and then performing the heat treatment process using the atmospheric gas at the second pressure higher than the atmospheric pressure to thus strengthen the insulation film, thereby improving the qualitative property of the insulation film without relying on the excessive processing time or temperature.

### [Description of Drawings]

FIG. 1 is a conceptual diagram of a high-pressure wafer processing apparatus 100 used to perform an insulation film manufacturing method of a semiconductor process according to an embodiment of the present invention.
FIG. 2 is a block diagram for describing a control operation of the high-pressure wafer processing apparatus 100 in FIG. 1.
FIG. 3 is a flowchart for describing the insulation film manufacturing method of a semiconductor process according to an embodiment of the present invention.
FIG. 4 is a flowchart for describing pressure and temperature controls to perform the insulation film manufacturing method of a semiconductor process according to an embodiment of the present invention.
FIG. 5 is a comparative graph of step coverage of an insulation film manufactured by following some steps of the insulation film manufacturing method of a semiconductor process in FIG. 3.
FIG. 6 is a comparative graph of a wet etch rate of the insulation film manufactured by the insulation film manufacturing method of a semiconductor process in FIG. 3.

### [Best Mode]

Hereinafter, an insulation film manufacturing method of a semiconductor process according to a preferred embodiment of the present invention is described in detail with reference to the attached drawings. Throughout the specification, components that are the same as or similar to each other are denoted by reference numerals that are the same as or similar to each other even in a different embodiment, and a description thereof is replaced by the first description.

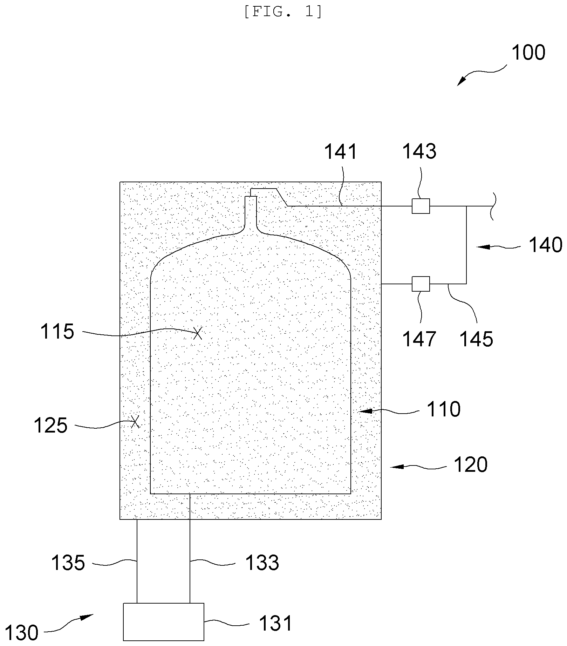

FIG. 1 is a conceptual diagram of a high-pressure wafer processing apparatus 100 used to perform an insulation film manufacturing method of a semiconductor process according to an embodiment of the present invention.

Referring to this drawing, the high-pressure wafer processing apparatus 100 may include an internal chamber 110, an external chamber 120, a gas supply module 130, and a gas exhaust module 140.

The internal chamber 110 has a processing area 115 for high-pressure processing a semiconductor wafer. The internal chamber 110 may be made of a non-metallic material, for example, quartz, to reduce a possibility that contaminants (particles) occur in a processing environment. Although simplified in the drawing, a door (not shown) for opening the processing area 115 may be disposed at a lower end of the internal chamber 110. As the door descends, the processing area 115 may be opened, and the semiconductor wafer may be input into the processing area 115 while being mounted on a holder (not shown) . As a heater (not shown) disposed outside the internal chamber 110 is operated, a temperature of the processing area 115 may reach several hundred degrees Celsius. The holder may be a wafer boat capable of stacking the semiconductor wafers in a plurality of layers. The wafer boat may also be made of a quartz material.

The external chamber 120 may accommodate the internal chamber 110. Unlike the internal chamber 110, the external chamber 120 is free from a semiconductor wafer contamination problem, and may thus be made of a metal material. The external chamber 120 may have an accommodation area 125 for accommodating the internal chamber 110. The external chamber 120 may also have a door (not shown) disposed at its lower portion. The door may descend together with the door of the internal chamber 110, and open the accommodation area 125.

The gas supply module 130 may supply gas to the chamber 110 or 120. The gas supply module 130 may have a gas supplier 131 communicate with the utility of a semiconductor factory. The gas supplier 131 may supply source gas, purge gas, and atmospheric gas to the internal chamber 110, specifically the processing area 115. The source gas may include, for example, oxygen gas, water vapor, or ammonia gas. The purge gas may include, for example, nitrogen gas, argon gas, or helium gas. The atmospheric gas may include, for example, hydrogen gas, deuterium gas, tritium gas, the nitrogen gas, or the argon gas. The gas supplier 131 may provide, for example, the nitrogen gas, the argon gas, or the helium gas, as a protective gas for the accommodation area 125. The protective gas may be selected as a gas of the same type as the purge gas. The protective gas injected in the accommodation area 125 may specifically fill a region of the accommodation area 125 that excludes the internal chamber 110. These gases may respectively be injected into the processing area 115 or the accommodation area 125 through an internal gas line 133 or an external gas line 135.

The source gas, the purge gas, the atmospheric gas, and the protective gas may be supplied to the internal chamber 110 or 120, to form a high pressure higher than an atmospheric pressure, for example, a high pressure ranging from several atmospheres to tens of atmospheres. In addition, a pressure of the protective gas may be set to have a certain relationship with pressures of the source gas, the purge gas, and the atmospheric gas. For example, the latter may be set to be slightly larger than the former to prevent the source gas, the purge gas, and the atmospheric gas from leaking from the processing area 115.

The gas exhaust module 140 may exhaust the source gas, the purge gas, the atmospheric gas, and the protective gas from the chamber 110 or 120. A gas exhaust pipe 141 may be connected to the top of the internal chamber 110 to exhaust the source gas or the atmospheric gas from the internal chamber 110, specifically the processing area 115. A gas exhaust 143 may be installed at the gas exhaust pipe 141. The gas exhaust 143 may be a valve that regulates the exhaust of the source gas or the atmospheric gas.

A gas exhaust pipe 145 communicating with the external chamber 120 and a gas exhaust 147 installed thereat may be provided to also exhaust the protective gas from the external chamber 120, specifically from the accommodation area 125. These gas exhaust pipes 141 and 145 may communicate with each other, and the source gas and the atmospheric gas may thus be exhausted while diluted in the protective gas.

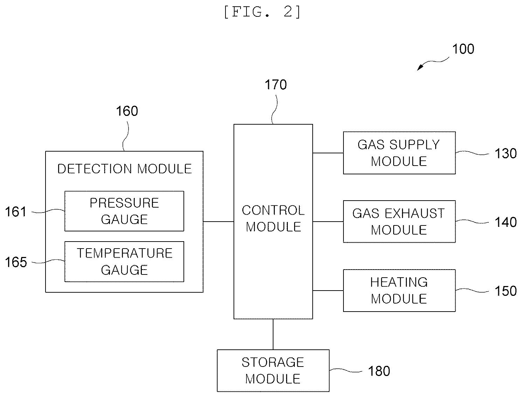

A control configuration of the high-pressure wafer processing apparatus 100 is described with reference to FIG. 2. FIG. 2 is a block diagram for describing a control operation of the high-pressure wafer processing apparatus 100 in FIG. 1.

Referring to this drawing (and FIG. 1), the high-pressure wafer processing apparatus 100 may further include a heating module 150, a detection module 160, a control module 170, and a storage module 180 in addition to the gas supply module 130 and the like, described above.

The heating module 150 may include the above-mentioned heater. The heater may be disposed in the accommodation area 125. The heater may heat the source gas, the purge gas, or the atmospheric gas to reach a process temperature.

The detection module 160 may detect an environment of the chamber 110 or 120. The detection module 160 may include a pressure gauge 161 and a temperature gauge 165. The pressure gauge 161 and the temperature gauge 165 may be installed at each of the chambers 110 and 120.

The control module 170 may control the gas supply module 130, the gas exhaust module 140, or the like. The control module 170 may control the gas supply module 130 or the like based on a detection result of the detection module 160.

The storage module 180 may store data, programs, or the like that the control module 170 may refer to for the control. The storage module 180 may include at least one type of storage medium among a flash memory, a hard disk, a magnetic disk, and an optical disk.

According to this configuration, the control unit 170 may control the gas supply module 130 or the like to perform the insulation film manufacturing method of a semiconductor process according to an embodiment of the present invention.

In detail, the control unit 170 may control an operation of the gas supply module 130 based on a pressure in the chamber 110 or 120 that is acquired through the pressure gauge 161. By the operation of the gas exhaust module 130, the internal chamber 110 may be filled with the source gas, the purge gas, or the atmospheric gas at a process pressure. On the other hand, the external chamber 120 may be filled with the protective gas.

The control unit 170 may control an operation of the heating module 150 based on a temperature of the chamber 110 or 120 that is acquired through the temperature gauge 165. By the operation of the heating module 150, the source gas, the purge gas, or the atmospheric gas may reach the process temperature.

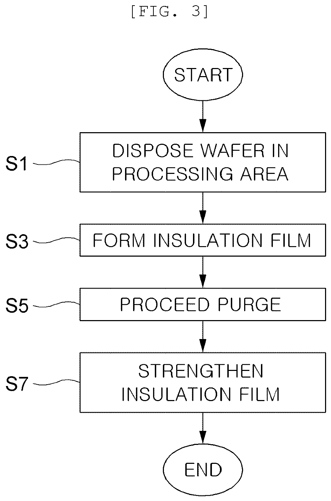

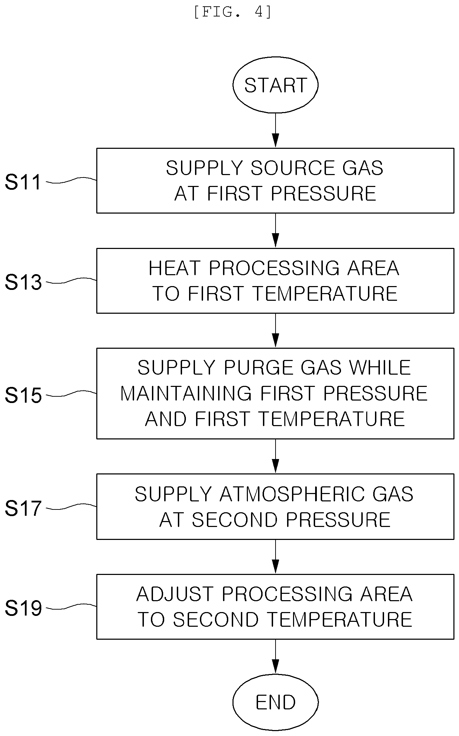

The description describes a specific method of forming an insulation film on the wafer by using the high-pressure wafer processing apparatus 100 described above with reference to FIGS. 3 and 4.

FIG. 3 is a flowchart for describing the insulation film manufacturing method of a semiconductor process according to an embodiment of the present invention.

Referring to this drawing (and FIGS. 1 and 2), the wafer may be disposed in the processing area 115 (S1). The wafer may be input into the processing area 115 while seated on the wafer boat.

The insulation film may be formed on the wafer in the processing area 115 (S3). The insulation film may be a silicon oxide film (SiO) made of silicon oxide, a silicon nitride film (SiN) made of silicon nitride, or a silicon nitride film (SiON) including both the silicon oxide and the silicon nitride. In order to form the insulation film, an oxidation process or a nitridation process may be performed at a first pressure in the processing area 115. The first pressure may be a pressure higher than the atmospheric pressure.

After completion of the oxidation or nitridation process, gas used in the oxidation or nitridation process may be purged (S5) . Accordingly, the processing area 115 may be in a state for performing a process other than the oxidation or nitridation process.

After completion of the purging, the insulation film may be strengthened through a heat treatment process (S7). The heat treatment process may be performed at a second pressure. The second pressure may be a pressure higher than the atmospheric pressure.

FIG. 4 is a flowchart for describing pressure and temperature controls to perform the insulation film manufacturing method of a semiconductor process according to an embodiment of the present invention.

Referring further to this drawing, for the oxidation or nitridation process, the source gas may be supplied to the processing area 115 at the first pressure (S11). Among the source gases, the oxygen gas may be supplied for dry oxidation, and the water vapor may be supplied for wet oxidation. The ammonia gas may be supplied for nitridation. The first pressure may be determined within a range of 5 ATM to 20 ATM.

In order for the source gas to reach the process temperature, the processing area 115 may be heated to a first temperature (S13). The first temperature may be determined within a range of 400°C to 950°C. The source gas acts at a high pressure (the first pressure), and the first temperature may thus be set to 600°C or lower. This temperature may be relatively low compared to a temperature of a general deposition process.

After completion of the oxidation or nitridation, the purge gas may be supplied to the processing area 115 while maintaining the first pressure and the first temperature (S15). The control module 170 may control the gas exhaust module 140 and the gas supply module 130 together to allow the source gas to be purged and exhausted from the processing area 115. A time required for this purge process may be shorter than a time required for the oxidation or nitridation process.

To perform the heat treatment process, the atmospheric gas may be supplied to the processing area 115 at the second pressure (S17). The second pressure may be determined within the range of 5 ATM to 20 ATM. The second pressure may be set independently of the first pressure. Accordingly, the second pressure may be the same as or different from the first pressure. The control unit 170 may control the gas exhaust unit 140 and the gas supply unit 130 together to thus allow the atmospheric gas to be supplied to the processing area 115 and the purge gas to be exhausted from the processing area 115.

In order to bring the atmospheric gas to the process temperature required for the heat treatment process, the processing area 115 may be adjusted to a second temperature (S19). The second temperature may be determined within the range of 400°C to 950°C. The atmospheric gas may act at the high pressure (the second pressure), and the second temperature may thus be set to 600°C or lower. The second temperature may also be set independently of the first temperature. For temperature control, the control module 170 may additionally operate the heating module 150, operate cooling means (not shown), or maintain an existing temperature.

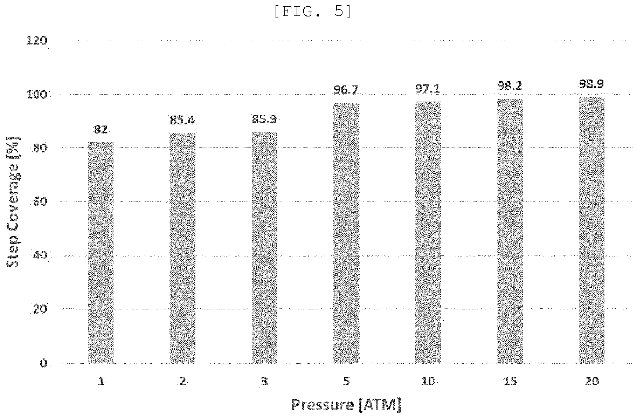

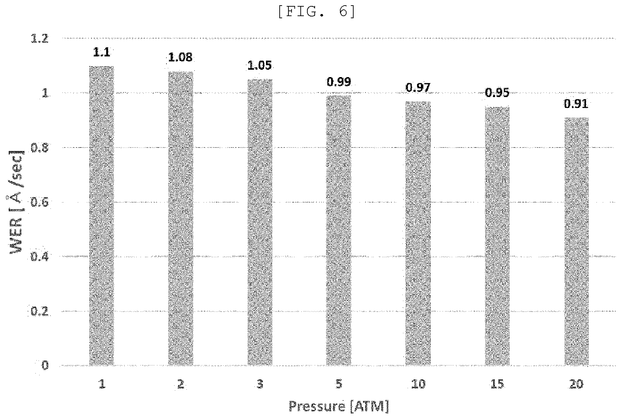

Settings of the first and second pressures are further described with reference to FIGS. 5 and 6. FIG. 5 is a comparative graph of step coverage of an insulation film manufactured by following some steps of the insulation film manufacturing method of a semiconductor process in FIG. 3; and FIG. 6 is a comparative graph of a wet etch rate of the insulation film manufactured by the insulation film manufacturing method of a semiconductor process in FIG. 3. In detail, FIG. 5 shows a result of forming a silicon dioxide film (SiO2) by performing the oxidation process on a patterned silicon wafer and comparing the step coverage of the film. FIG. 6 shows a result of strengthening the silicon dioxide film through the heat treatment process and comparing the wet etch rate (WER) of the strengthened film.

The oxidation process is performed as a wet oxidation process. In the heat treatment process, the atmospheric gas is the hydrogen gas. In the oxidation process, the heat treatment process, and the purge process between these processes, the process temperature is maintained at 600°C. The oxidation process and the heat treatment process are respectively performed for 1 hour, and the purge process is performed for 20 minutes. Each process is performed using an in-situ method in the processing area 115. The process pressure is controlled under a high pressure condition (ranging from 1 ATM to 20 ATM). A solution used for wet etching is a mixture of 1 part by weight of hydrofluoric acid per 100 parts by weight of pure water.

Referring to FIG. 5, when the first pressure is increased from 1 ATM to 20 ATM in the oxidation process, the step coverage of the silicon dioxide film is also increased.

For example, the step coverage of the silicon dioxide film is 82% at 1 ATM, and 85.4% at 2 ATM. The step coverage is increased to 85.9% at 3 ATM, which is only a minimal increase.

However, the step coverage is significantly increased at 5 ATM to thus reach 96.7%. As the first pressure is increased to 10 ATM, 15 ATM, or 20 ATM, the step coverage becomes 97.1%, 98.2%, or 98.9%.

Considering such a result, it is preferable in terms of the step coverage that the first pressure is 5 ATM or more. The first pressure may be set to 20 ATM in order to acquire the best step coverage.

Referring to FIG. 6, the heat treatment process is performed on the silicon dioxide film, made in the oxidation process (at 20 ATM), at the second pressure. It may be seen that the wet etch rate of the silicon dioxide film is decreased when the second pressure is increased from 1 ATM to 20 ATM. The wet etch rate is inversely proportional to density of the silicon dioxide film. Considering this relationship, it is possible to use the wet etch rate to thus check an improved film quality (increased density) of the oxide film according to this embodiment.

However, when the second pressure is 1 ATM to 3 ATM, the wet etch rate is higher than 1 Å/sec. To acquire a wet etch rate lower than 1 Å/sec, the second pressure needs to be set to 5 ATM or more. In detail, the wet etch rate at 5 ATM is 0.99 Å/sec, which is within a desired range.

Further, as the second pressure is increased to 10 ATM, 15 ATM, or 20 ATM, the wet etch rate becomes 0.97 6Å/sec, 0.95 Å/sec, or 0.91 Å/sec.

Considering such a result, it is preferable in terms of the wet etch rate that the second pressure is 5 ATM or more. To acquire the best wet etch rate, the second pressure may be set to 20 ATM.

The insulation film manufacturing method of a semiconductor process as described above is not limited to the configuration and operation method in the embodiments described above. The embodiments described above may be variously modified by selective combinations of all or some of the respective embodiments.

### [Industrial Applicability]

The present invention has potential industrial application in a field of manufacturing an insulation film in a semiconductor process.

## Claims

1. An insulation film manufacturing method of a semiconductor process, the method comprising:
disposing a wafer in a processing area;
forming an insulation film on the wafer by supplying source gas to the processing area at a first pressure higher than an atmospheric pressure to thus perform at least one of an oxidation process and a nitridation process;
purging the source gas by supplying purge gas to the processing area; and
strengthening the insulation film by supplying atmospheric gas to the processing area at a second pressure higher than the atmospheric pressure to thus perform a heat treatment process.

2. The method of claim 1, wherein the first pressure has a determined value within a range of 5 ATM to 20 ATM.

3. The method of claim 1, wherein the forming of the insulation film on the wafer by supplying the source gas to the processing area at the first pressure higher than the atmospheric pressure to thus perform the at least one of the oxidation process and the nitridation process includes maintaining the source gas at a first temperature, and
the first temperature has a determined value within a range of 400°C to 600°C..

4. The method of claim 1, wherein the source gas includes at least one of oxygen gas, water vapor, and ammonia gas.

5. The method of claim 1, wherein the purging of the source gas by supplying the purge gas to the processing area is performed while maintaining the processing area at the first pressure and a first temperature.

6. The method of claim 1, wherein the purge gas includes one of nitrogen gas, argon gas, and helium gas.

7. The method of claim 1, wherein the second pressure has a determined value within a range of 5 ATM to 20 ATM.

8. The method of claim 1, wherein the atmospheric gas includes at least one of hydrogen gas, deuterium gas, and nitrogen gas.

9. The method of claim 1, further comprising maintaining an accommodation area accommodating the processing area at a pressure higher than one of the first pressure and the second pressure while the processing area is maintained at one of the first pressure and the second pressure.
